# EUROPEAN PATENT APPLICATION

(11) **EP 4 786 368 A1**
(43) Date of publication of application: **05.08.2026**
(21) Application number: 26151383.2
(22) Date of filing: 03.07.2018
(51) Int. Cl.: B65D 85/04, B65H 49/38, B65H 75/14, H10W 72/00, H10W 72/50

(54) **WINDING STRUCTURE OF BONDING WIRE AND SPOOL CASE**

(30) Priority: 04.07.2017 JP 2017130910; 26.01.2018 WO PCT/JP2018/002398
(62) Divisional of application: 18828058.0
(71) Applicant: Tanaka Electronics Co., Ltd., Saga 842-0031 (JP)
(72) Inventor: KIMURA, Nobuyuki, Saga, 8420031 (JP); OTSU, Sachihiro, Saga, 8420031 (JP); YANAI, Hirofumi, Saga, 8420031 (JP)
(74) Representative: Plougmann Vingtoft a/s

(57) **Abstract**

An object of the present invention is to provide a winding spool for bonding wires, a winding structure for the winding spool, and a spool case for storing the spool, wherein a bonding wire wound on the spool has excellent unwinding properties against vibration and impacts occurring during long-distance transportation or attachment to a bonding device. The winding spool of the present invention is a winding spool for a bonding wire, the winding spool being made of a synthetic resin and comprising a perforated guide portion, a drum portion, and flange portions, wherein an inner surface of each flange portion has an inclined portion having an elevation angle of 76 degrees or more and 86 degrees or less, and the inclined portion has a vertical height (h) that is 50% or more of a vertical height (H) of the entire inner surface of the flange portion, whereby the problems can be solved. Moreover, a larger impact can be solved by the winding structure of a bonding wire of the present invention; that is, the height of an edge of the drum portion on which the bonding wire is wound is higher than the height of the center of the drum portion. In addition, a further larger impact can be solved by using the spool case for winding spools of the present invention. That is, in the spool case for winding spools comprising a cover portion and a body made of a synthetic resin, the body has an approximately square pyramid trapezoidal shape with an opening on a side of the cover portion, and side facing surfaces of the body each have one or more expanded portions.

## Description

### Technical Field

The present invention relates to a winding spool for bonding wires and a production method thereof, a winding structure of a bonding wire and a winding method therefor, a bonding method, and a spool case for winding spools and a production method thereof.

### Background Art

Various spools for winding bonding wires have been developed so far; however, vibration and rolling during long-distance transportation are transferred to spools, thereby causing loosening and bias of the bonding wires wound on the spools. When the wire was loosened, the wound wire was suspended, and the wire entered the suspended space to create a state like tied strings, which often caused a defect that the wire was tangled and could not be smoothly supplied during the supply of the wire in wire bonding.

Moreover, there was another defect that when a spool on which a bonding wire was wound was installed on a wire bonding device, an impact was transferred to the spool to thereby form gaps between the wound wires and between the wires and the flanges so that the wire was dropped into the gaps, and the wire dug into the gaps and could not be smoothly supplied during the supply of the wire.

### Summary of Invention

### Technical Problem

In view of the above circumstances, an object of the present invention is to provide a winding spool for bonding wires and a production method thereof, a winding structure of a bonding wire and a winding method therefor, a bonding method, and a spool case for winding spools and a production method thereof for improving the unwinding properties of a synthetic resin spool when a wire is supplied from a bonding device, regarding winding loosening and cross winding caused by vibration and horizontal rolling during transportation, wire dropping, and digging into gaps formed between the wires and between the wires and flanges due to vibration and impacts occurring during attachment to the bonding device.

### Solution to Problems

In order to solve the above problems, the present inventors started from the cause analysis of why unwinding properties are deteriorated. Winding spools for bonding wires are roughly divided into anodized metal spools and spools made of a synthetic resin such as polycarbonate. As bonding wires for semiconductor devices, ultrafine wires made of gold and having a diameter of 30 µm or less are used, and 3000 to 5000 m of such wires are wound on metal spools. In contrast, thick wires, such as aluminum wires having a diameter of 75 µm to 800 µm, are used as bonding wires for power devices. For winding thick wires, spools larger than those for ultrafine wires are required, and resin winding spools are used because of the production cost of spools.

It was found that, since wires used as aluminum bonding wires for power devices were thicker than gold ultrafine bonding wires, when such a wire was wound on a spool, the filling rate of the wound wire was lower than that of an ultrafine wire. That is, the wire is loosely wound with large gaps between the wires. It was also found that, since the specific gravity of aluminum was 7 times smaller than that of gold, it was vulnerable to horizontal rolling and vibration, and was prone to winding loosening. Winding loosening causes wire entanglements, and wire crossing may cause disconnection. Therefore, the wire cannot be smoothly supplied by a bonding device, and the device stops, thereby significantly reducing the productivity of the wire bonding process.

In addition, a smaller amount of wire with a thick wire diameter can be wound on a spool than an ultrafine wire. If the winding amount is small, the frequency of exchanging spools attached to the bonding device increases, which significantly impairs productivity. Therefore, in order to wind a larger amount of wire, the wire is wound from one flange of a resin spool to the other flange. The wire can be wound to the vicinity of the flange portion; however, it was found that, since the wire had a round shape, even if the wire was wound to the full extent, gaps were inevitably formed between the place where the wire was wound and the flanges. In a little more detail, even if the first layer of the wire that begun to be wound on the spool drum portion was wound tightly from one flange to the other flange without space, the layer above the first layer wound next was not directly above the wire of the first layer, but was wound on a gap between the wires of the first layer, or a portion slightly shifted from the gap. Thus, it was clarified that the wire of the layer above the first layer inevitably had gaps between the flanges and the wires.

On the other hand, resin spools have the disadvantage that they are weaker than metal spools. When a spool is set to a bonding device, it must be firmly fixed with force so that there is no idle or play. Accordingly, the flanges are firmly pressed to install the spool. At this time, the kinds of processes and phenomena occurring in the flange portions and the wound wire were carefully observed and examined. When a spool was attached to a bonding device, the flanges and the wires wound near the flanges were once pushed inside the drum portion. After that, the flanges returned to their original positions; however, the wires were left behind inside, and it was found that the gaps between the wires and flanges widen. Then, it was clarified that since the wire was dropped into the gaps, the wire dug thereinto, thereby causing a defect that the wire could not be supplied during the supply of the wire.

In addition, regarding wire unwinding properties, transportation problems were examined. Naturally, there is a problem of vibration in transportation. Vibration causes winding collapse of the wire, and formation of gaps between the wires. Further, it was found that dropping of the wire into gaps between the wires and the flanges was caused by not only vibration and impacts during transportation, but also the shrinkage of the resin due to temperature differences. In particular, it was clarified that in the case of air transportation, since there was a large temperature difference between the ground and the sky, when the flanges shrunk in the sky at low temperatures and formed gaps, the wire was dropped thereinto; and that since the temperature on the ground was higher than that on the sky, when the flanges expanded and returned to their original positions, there was a defect that the wire dug in and could not be supplied.

As described above, the size of the resin spool slightly changes because of, for example, attachment to the bonding device and repeated shrinkage of the spool resin due to vibration during transportation and temperature changes during air transportation. Since resin spools are washed and reused after the wire is unwound, the reused spools have more unwinding defects than new spools. That is, it was found that the larger the number of reuses, the larger the dimensional error; and that thus, if the flanges spread when the wire was wound, gaps were formed between the wires and the flanges, and the wire was dropped into the gaps, thereby causing more unwinding defects. As an example, a specific means for solution is explained in detail below with figure numbers assigned.

The winding spool of the present invention is a winding spool for a bonding wire, the winding spool being made of a synthetic resin and comprising a perforated guide portion 14, a drum portion 12, and flange portions 13, wherein the inner surface of each flange portion 13 has an inclined portion having an elevation angle 19 of 76 degrees or more and 86 degrees or less, and the inclined portion has a vertical height (h) that is 50% or more of a vertical height (H) of the entire inner surface of the flange portion.

Moreover, the winding structure of the bonding wire of the present invention is a winding structure of a bonding wire wound on a winding spool made of a synthetic resin and comprising a perforated guide portion 14, a drum portion 12, and flange portions 13, wherein the inner surface of each flange portion 13 has an inclined portion having an elevation angle 19 of 76 degrees or more and 86 degrees or less, the inclined portion has a vertical height (h) that is 50% or more of a vertical height (H) of the entire inner surface of the flange portion, and the height of an edge of the drum portion on which the bonding wire 42 is wound is higher than the height of the center of the drum portion.

Furthermore, the spool case for winding spools of the present invention is a spool case for a winding spool, the spool case comprising a cover portion 21 and a body 31 made of a synthetic resin, wherein the body has an approximately square pyramid trapezoidal shape with an opening on a side of the cover portion, and side facing surfaces of the body each have one or more expanded portions 34.

Here, the "synthetic resin" in the above winding spool and winding structure generally refers to a plastic resin formed by injection molding of a synthetic resin. Synthetic resins can be molded by injection molding, die pressing, embossing, vacuum molding, or the like. Examples of the synthetic resin include ABS resin, polycarbonate resin, impact-resistant polystyrene, and the like.

Here, the "inclined portion" of the flange portion 13 of the above winding spool refers to an inclined portion having a vertical height (h) that is 50% or more of the vertical height (H) of the entire inner surface of the flange portion, and having an elevation angle 19 of 76 degrees or more and 86 degrees or less.

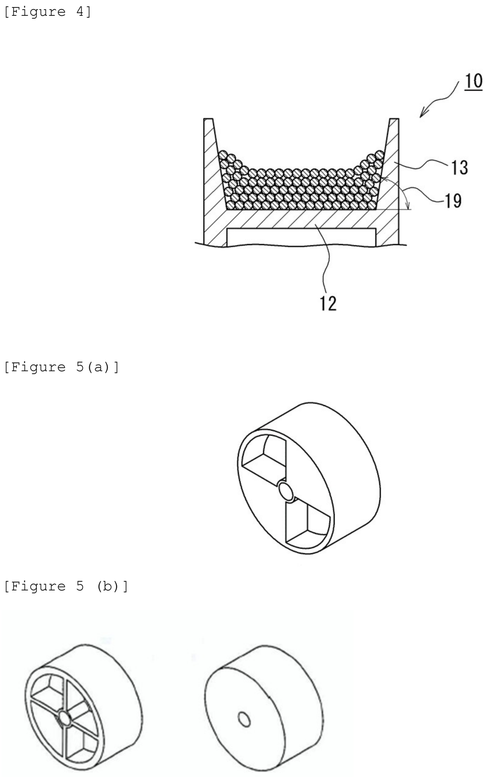

Here, the "elevation angle" refers to an angle between the drum portion 12 and the inner surface of the flange portion 13. Fig. 4 shows the elevation angle 19 of a typical flange portion 13. Here, the "elevation angle" includes an angle at the point where the drum portion intersects the extended line of the inclined portion.

In the flange portion 13 of the above winding spool, "the inclined portion has a vertical height (h) that is 50% or more of the vertical height (H) of the entire inner surface of the flange portion" for the following reason. That is, if the vertical height (h) of the inner surface of the flange portion 13 is less than 50% of the vertical height (H) of the entire inner surface of the flange portion 13, the force in the vertical direction of the wound bonding wire increases, the wire is likely to drop into gaps, and the winding amount of the bonding wire decreases. The height of the inclined portion of the winding spool can be measured using a caliper, a ruler, a laser microscope, or the like.

Moreover, in the above winding spool, "the inner surface of the flange portion has an elevation angle 19 of 76 degrees or more and 86 degrees or less" for the following reason. That is, if the elevation angle 19 of the flange portion 13 exceeds 86 degrees, a large force acts in the vertical direction as described above, so that the wire is likely to drop into gaps between the wound wires or between the wires and the flange portions 13. Further, if the elevation angle 19 of the flange portion 13 is less than 76 degrees, the angle is mild, so that the wound wire on the surface layer is shaken from side to side due to a horizontal impact, thereby causing a winding flaw. Moreover, since there is a standard for the size of spools attached to bonding devices, the length of the drum portion and the flange diameter are also limited. Therefore, if the elevation angle of the flange portion is small, the winding amount of the bonding wire decreases. If the winding amount decreases, the frequency of exchanging spools in the bonding process increases, and productivity is significantly reduced. The elevation angle 19 of the inclined portion of the flange portion 13 is more preferably 79 degrees or more and 83 degrees or less.

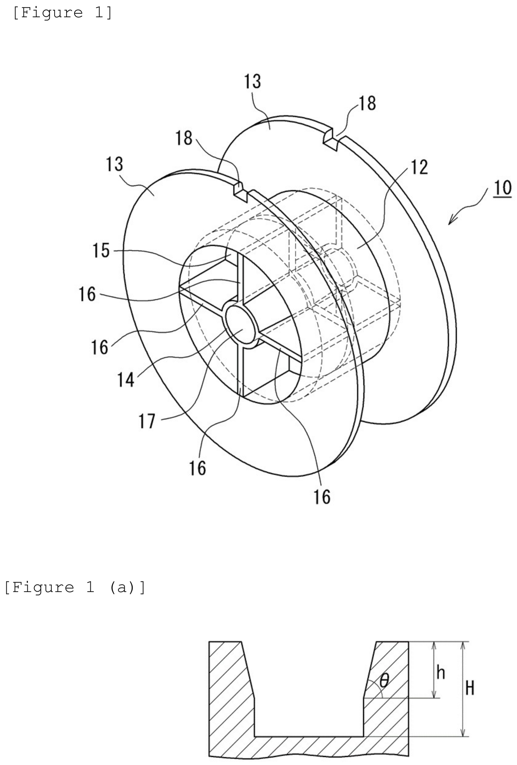

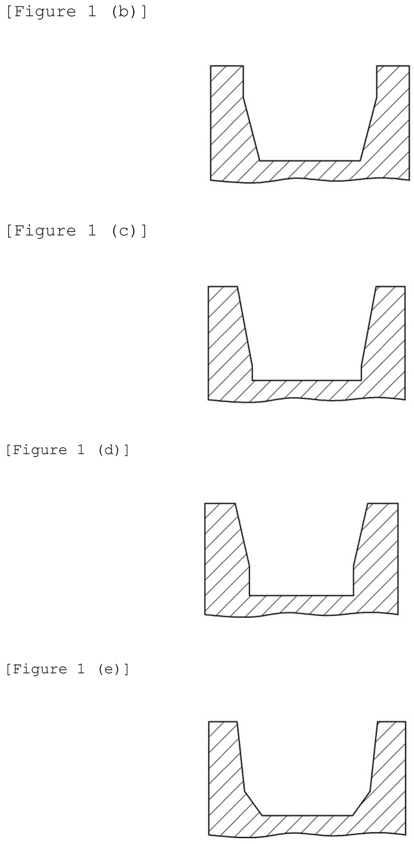

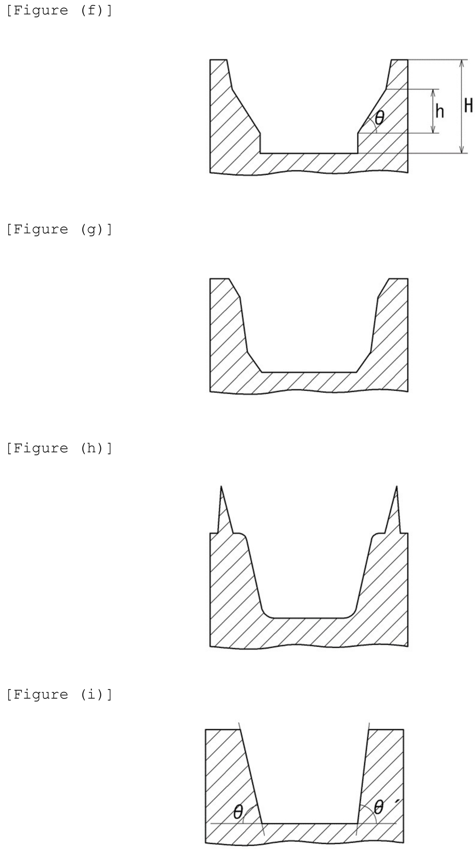

Regarding the inclination of the flange portion 13 of the winding spool 10, the problems of the present invention can also be solved, for example, when there are two inclinations, as shown in Figs. 1 (a), (b), (c), (d), and (e), or when there are three inclinations, as shown in Figs. 1 (f) and (g). Further, the vertical height (H) does not include the height of a projection etc. on the flange as shown in Fig. 1 (h), and even when the left and right flanges have different elevation angles as shown in Fig. 1 (i), the problems of the present invention can also be overcome. Figs. 1 (a) and (f) show the vertical height (H) of the entire inner surface of the flange portion, the vertical height (h) of the inclined portion of the inner surface of the flange portion, and elevation angles "θ" and "θ'."

Here, the "height of an edge" in the winding structure of the bonding wire of the winding spool 10 is defined as the height of the bonding wire wound in a space between the flange portion and a line assumed to be drawn from the intersection of the flange portion inner surface and the drum portion in the winding structure, i.e., the starting point at which the flange portion rises, in a direction perpendicular to the drum portion. Further, the "height of the center of the drum portion on which the bonding wire 42 is wound" is defined as the height of the outermost layer of the bonding wire wound on the drum portion other than the edges.

Moreover, the feature that "the height of an edge of the drum portion on which the bonding wire 42 is wound is higher than the height of the center of the drum portion" in the winding structure of the bonding wire is because gaps between the wound bonding wires 42 and gaps between the bonding wires 42 and the flange portions 13 can be filled, and defects of the wire being caught during the supply of the wire due to dropping of the bonding wire 42 into such gaps can be prevented.

The feature that "the height of an edge of the drum portion on which the bonding wire 42 is wound is higher than the height of the center of the drum portion" can be visually confirmed in most cases; however, it can also be confirmed by screen projection or using a laser microscope, a length measurement microscope, or a roughness meter. In the winding structure of the present invention, it is preferable that the height of an edge of the drum portion on which the bonding wire 42 is wound be higher than the height of the center of the drum portion by the radius of the wound bonding wire or more, and more preferably by one wound bonding wire, i.e., the diameter of the wound bonding wire or more.

Here, the "approximately square pyramid trapezoidal shape" in the above spool case for winding spools refers to a truncated pyramid with a square opening; however, the winding spool opening may have a polygonal shape or a shape with rounded corners.

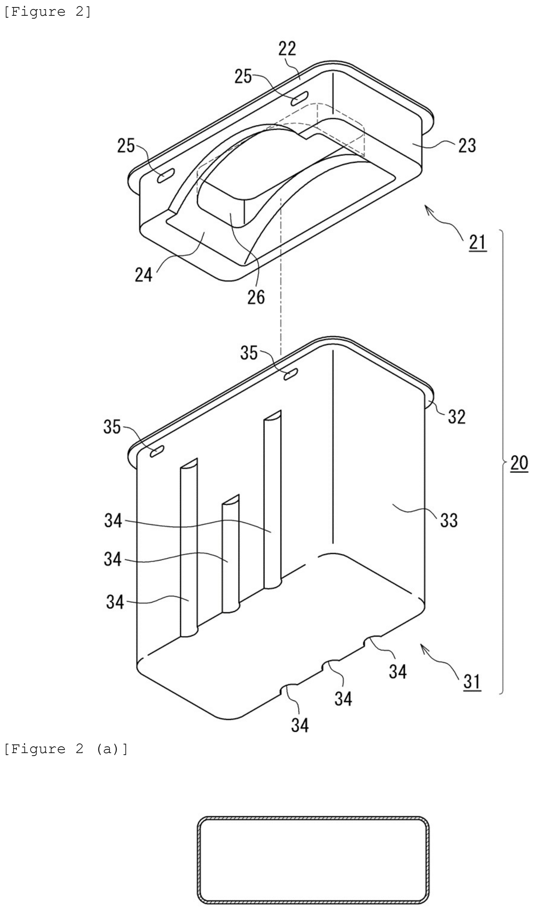

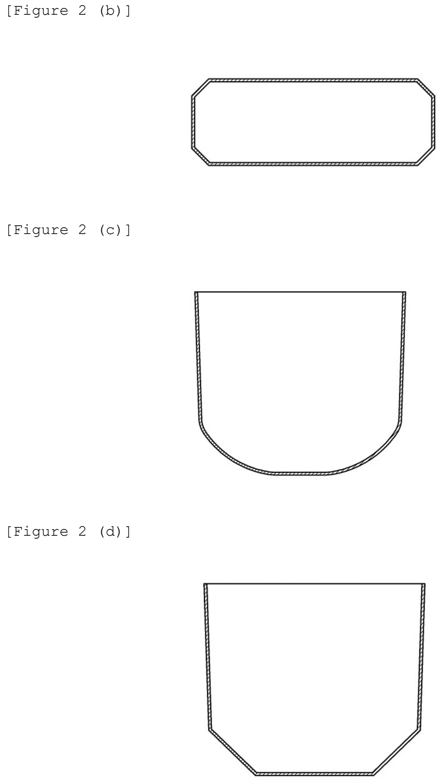

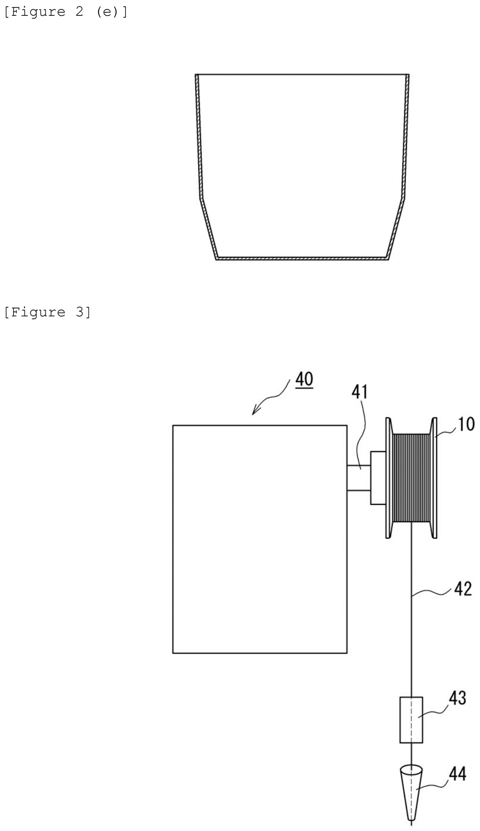

Moreover, the "expanded portion" as mentioned herein refers to a structure that is provided inside the body 31 with an approximately square pyramid trapezoidal shape is raised inwardly to be in point contact or line contact with the flange portion of the stored winding spool. As shown in Fig. 2, a plurality of wave grooves is a typical example; however, other shapes may be used, as long as they can make point contact or line contact. In terms of making point contact or line contact, the expanded portion is preferably a ridge or a protrusion.

In the above spool case for winding spools of the present invention described above, the body 31 has an approximately square pyramid trapezoidal shape with an opening on a side into which the winding spool is inserted, as shown in Fig. 2. The opening of the body 31 on the cover portion side may have a polygonal shape or a curved shape. The thickness of the spool case body 31 made of a synthetic resin is preferably 0.1 mm or more and 0.9 mm or less, and particularly preferably 0.2 mm or more and 0.5 mm or less.

Next, Figs. 2 (a) to (e) show embodiments of the spool case body 31. Figs. 2 (a) and (b) each show the opening of the spool case body 31; Fig. 2 (a) shows an opening with rounded corners, and Fig. 2 (b) shows an opening with polygonal corners. Figs. 2 (c) to (e) show vertical cross-sectional views of the spool case body 31; Fig. 2 (c) shows a case with rounded angles at the tip portions, and Figs. 2 (d) and (e) show cases with two or more inclined angles at the tip portions. The problems of the present invention can also be solved with these shapes.

Further, the spool case for winding spools has "one or more expanded portions 34" for the following reason. That is, because the spool and spool case are in point contact or line contact with each other, a space is formed between the spool and spool case to disperse an impact from the outside, thereby mitigating a direct impact on the spool.

An embodiment of the winding spool for bonding wires of the present invention is as described below. It is preferable that 2 or more and 6 or less reinforcing ribs 16 be connected to the outer peripheral surface of the perforated guide portion and the inner peripheral surface of the drum portion on one or both sides. The strength of the winding spool is higher than that without reinforcing ribs 16. It is possible to prevent the deformation of the flange portions 13 due to pressure and impacts during attachment to a bonding device and winding collapse due to the deformation of the flange portions 13, as well as digging and catching of the bonding wire 42 because it is dropped into gaps between the flange portions 13 and the bonding wire 42 formed due to winding collapse. Further, reinforcement by the reinforcing ribs contributes to higher resistance to horizontal impacts and vibration and tolerance to long-term transportation. Moreover, even if such a spool is repeatedly set to a bonding device, the reinforcing ribs disperse impacts so that the deformation and deterioration of the flanges can be suppressed. Since the spool is reused repeatedly, it is very useful that the spool is not deformed or deteriorated.

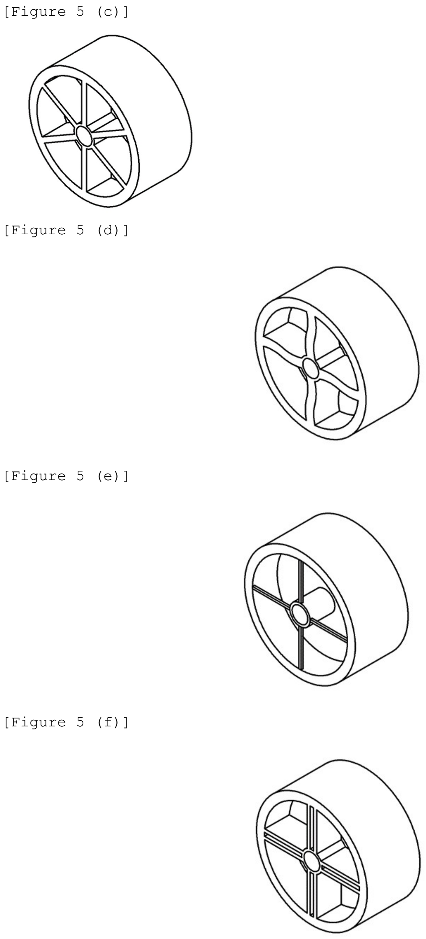

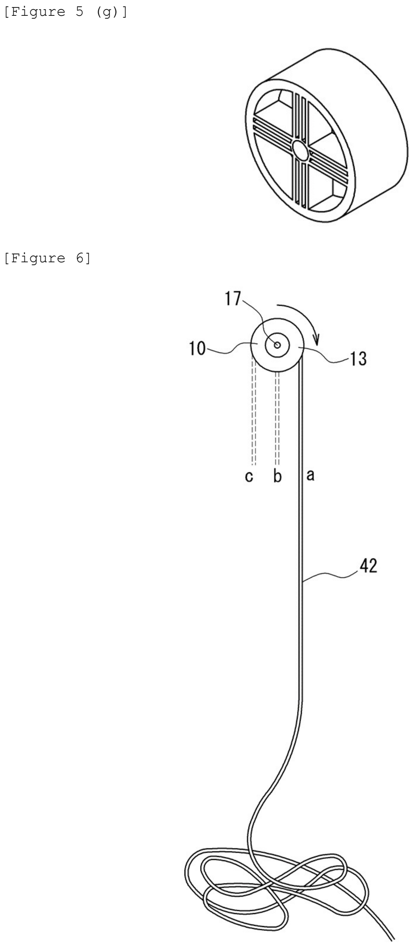

Embodiments of the reinforcing ribs of the present invention are shown below. Fig. 5 (a) shows reinforcing ribs that fill part of a flange. Fig. 5 (b) shows a flange in which one side is completely filled and has no cavity, and the other side has four reinforcing ribs. Fig. 5 (c) shows six reinforcing ribs. Fig. 5 (d) shows curved reinforcing ribs, Fig. 5 (e) shows rectangular rod-like reinforcing ribs, Fig. 5 (f) shows reinforcing ribs, two of which form one shape, and Fig. 5 (g) shows reinforcing ribs, three of which form one shape. Figs. 5 (a) to (g) are schematic diagrams of the inner surface of the drum portion. Fig. 5 (b) shows both sides of a flange, and the other figures show reinforcing ribs only on one side of a flange.

It is also preferable that the winding spool 10 for bonding wires and the spool case 20 be transparent. This is because the internal structure, including the bottom on which the bonding wire is wound, can be visually observed from the outside of the spool case 20, so that defects on the wire surface, such as a winding flaw and adhesion of foreign matter, can be easily found. The degree of transparency may be such that collapse etc. of the wire can be visually recognized. In addition, since colorants added to colored resins have a large shrinkage rate due to heat, the size of the spool itself slightly changes when expansion and shrinkage are repeated. Therefore, gaps are formed between the wires and the flanges, thereby causing wire dropping and digging. For this additional reason, the spool resin is preferably transparent.

Moreover, it is preferable that the bonding wire 42 be aluminum metal or an aluminum alloy. Alternatively, a bonding wire in which aluminum metal or an aluminum alloy is used as a wire core material, and the core material is coated with a metal other than the core material, may be used. Other examples of the material of the bonding wire 42 of the present invention include pure silver or silver alloys, pure copper or palladium-coated copper alloys, etc.; however, winding spools 10 for thick bonding wires 42 of an aluminum alloy, which has low specific gravity, can more effectively solve problems such as winding collapse. When a thick bonding wire of aluminum metal or an aluminum alloy, which has low specific gravity, is wound on the winding spool, a higher effect of suppressing winding collapse is obtained when the wire diameter is 75 µm or more and 800 µm or less.

In the spool case 20 for winding spools of the present invention, it is preferable that the cover portion does not allow oxygen and moisture to pass through and be a peelable film. Specific materials for the film include polyvinylidene chloride (PVDC), polyethylene terephthalate (PET), polypropylene (PP), polyethylene (PE), and the like. This is because these materials can be expected to be effective in preventing oxidation and corrosion due to ingress of oxygen and moisture during transportation and storage of the bonding wire 42 wound on the winding spool 10. Impermeability of oxygen and moisture can be measured using a commercially available oxygen permeability measuring device (e.g., OX-TRAN 2/22, produced by MOCON). The oxygen permeability (according to JIS standard: JIS K 7126) is preferably 3000 cm³/(m²·24h·atm) or less, more preferably 1000 cm³/(m²·24h·atm) or less, even more preferably 300 cm³/(m²·24h·atm) or less, and most preferably 100 cm³/(m²·24h·atm) or less. If the oxygen permeability is appropriate, water molecules larger than oxygen molecules will not permeate; therefore, oxygen and water molecules will not permeate.

Moreover, it is preferable that the cover portion 21 be made of a synthetic resin, have a fitting projection 23 having an approximately square pyramid trapezoidal shape in the inside of an outer peripheral flange 22, that the fitting projection 23 have a circular arc groove 24 in the center thereof and engagement pieces 25 on the side walls thereof, and that the circular arc groove 24 have a shape along the outer peripheral edges of the left and right flange portions 13 of the winding spool 10 for bonding wires. This is because such a cover portion absorbs a large impact and converts it into a small impact, as with the above-mentioned film. The cover portion 21 and the body 31 may be used upside down with respect to Fig. 2; that is, the cover portion 21 may be used as the base of the spool case 20, and the body 31 may be used as the upper cover thereof.

As early synthetic resin winding spools for bonding wires, JPS58-151154U (Patent Document 1, described later) discloses a winding spool used to wind metal wires, such as tungsten and molybdenum. Winding spools common in 1982 were those comprising a cylindrical drum portion 2 and flange portions 3 and 3' provided on both ends of the drum portion, as shown in Fig. 1. The specification indicates that, however, in such winding spools, winding thickness is often uneven in the vicinity of the inner side surfaces of the flange portions 3 and 3' (the ends of the drum portion 2), as shown in Figs. 2 (a) and (b), and that winding collapse in the vicinity of the inner side surfaces of the flange portions and the tangling of wires due to wire digging into the lower layer are thus likely to occur.

Therefore, JPS58-151154U (Patent Document 1, described later) mentioned above shows a winding plate spool for thin metal wires, wherein "the inclination angle of the inner side surfaces of the flange portions relative to the axial direction is 20 degrees to 45 degrees (see claim (2) of the utility model application)," as shown in Fig. 3 of Patent Document 1. This suggests that Patent Document 1 shows a winding plate spool for thin metal wires, wherein the cross-sectional surface has an elevation angle of 20 degrees to 45 degrees. Patent Document 1 is an invention for winding thin wires, such as tungsten and molybdenum, and thus is different from the present invention. With flange portions having an elevation angle of 20 degrees to 45 degrees thick and light bonding wires such as aluminum wires, flaws appear on the winding surface layer, and the wire winding amount decreases.

Such an inclination angle is also provided in spools for winding semiconductor bonding wires comprising gold wires. For example, claim 1 of JP2001-85462A (Patent Document 2, described later) discloses "a spool for winding a semiconductor bonding wire, the spool comprising a drum and flanges provided in both ends of the drum, wherein the outer peripheral surface of the drum is provided with inclined side surfaces inclined from both ends of the drum toward the center." Fig. 2 of Patent Document 2 shows an example of a flange (2) having side surfaces (5) that are inclined on a plane, wherein the cross-sectional surface of each inclined side surface (5) has an elevation angle of about 60 degrees. Patent Document 2 is also a spool for winding a semiconductor bonding wire comprising a gold wire, and is thus different from the present invention. However, as described above, when the flange angle is about 60 degrees, there are problems that aluminum wires with a low specific gravity undergo winding collapse and that the winding amount decreases.

Claim 1 of JP2004-87536A (Patent Document 3, described later) discloses "a spool for bonding wires used to wind and unwind a wire, the spool comprising a winding drum portion for winding a wire and flange portions provided at both ends of the drum portion, wherein the winding drum portion has a concentric cylindrical shape in which the diameter of parts of the winding drum portion adjacent to the flange portions is different from the diameter of the center of the winding drum portion, the parts of the winding drum portion adjacent to the flange portions and the center of the winding drum portion are integrated through smooth inclined surfaces; the diameter of the parts of the winding drum portion adjacent to the flange portions is larger than the diameter of the center of the winding drum portion and smaller than the diameter of the flange portions, and the center of the winding drum portion and each smooth inclined surface have an angle of 10 to 60 degrees." Fig. 2 of Patent Document 3 shows a smooth inclined surface (4) having an angle (6), which is a depression angle of about 30 degrees. Paragraph [0019] of Patent Document 3 refers to an "Au wire having a diameter of 25 µm and a length of 2,000 m." This suggests that this spool is a spool for bonding wires for Au ultrafine wires. Patent Document 3 is also an invention of a bonding wire spool for Au ultrafine wires, and is thus completely different from the present invention. However, as described above, when the flange angle is about 10 to 60 degrees, with aluminum wires with a low specific gravity, flaws appear due to swinging from side to side upon a horizontal impact, and the winding amount problem cannot be overcome.

Claim 1 of JP2679697B (Patent Document 4, described later) discloses "a spool case for bonding wires, the spool case comprising a container body made of a synthetic resin and integrally comprising an upwardly expanded fitting projection that allows fitting of a cylindrical spool, and a cover fitting into the outer edge raised peripheral wall of the container body, wherein a portion of the fitting projection of the container body to be in contact with and support the spool has a polygonal shape in a plan view, and the portion has rounded corners." Fig. 1 of Patent Document 4 shows an example of the spool case. Paragraph [0021] of Patent Document 4 indicates that "in the spool case of the present invention, the corners are supported by the sides of the polygonal column; thus, the repulsive force of the corners increases, and the corners are firmly pressed to the spool, thereby holding the spool reliably and securely." Patent Document 4 relating to a spool case is also an invention of a spool case for spools wound with thin wires used for semiconductors and superconducting elements, and is thus different from the present invention. However, in this spool case, the spool flanges are in direct contact with the inside of the container body; thus, impacts during transportation and vibration in the production process are directly transferred to the spool, and winding of the bonding wire collapses. In addition, since the spool is stored in the spool case in the same direction as the wire winding direction, winding of the wire is more likely to collapse.

JP3533658B (Patent Document 5, described later) discloses an invention that has a similar spool adhesive effect. Specifically, claim 1 of Patent Document 5 discloses "a spool case for winding spools, the spool case comprising a container body and a cover, the container body being integrally provided with an upwardly expanded fitting projection that fits into the inner peripheral surface of a cylindrical spool and an outer edge raised peripheral wall that fits into the cover, and the cover fitting with the outer edge raised peripheral wall of the container body, wherein a groove into which flanges of the cylindrical spool fit from the outer periphery is circumferentially formed around the fitting projection of the container body." Fig. 2, etc., show examples of the spool case. This spool case is described as follows: "The spool case is able to securely fix the spool because the spool is supported at two portions, that is, the spool inner peripheral surface and the flange outer peripheral surface . . . (omitted). This is effective in preventing the following accidents: when the spool is removed, the spool is forced to be pulled by a strong force, thereby leading to accidental contact with the wire; and when the spool is insufficiently fixed in the container body and the spool is accidentally dropped when the cover of the spool case is opened. The spool case can sufficiently withstand repeated use" (paragraph [0024] of Patent Document 5). Patent Document 5 relating to an invention of a spool case is also a spool case for spools wound with thin bonding wires used for semiconductors and superconducting elements, and is thus different from the spool case of the present invention. However, in this case, the spool is also inserted in the same direction as the winding direction. As with the above-mentioned problems, the spool is likely to directly receive impacts and vibration, with winding collapse and a winding flaw of the bonding wire in the vertical direction still unable to be overcome.

### Reference Patent Literature

Patent Document 1: JPS58-151154U
Patent Document 2: JP2001-85462A
Patent Document 3: JP2004-87536A
Patent Document 4: JP2679697B
Patent Document 5: JP3533658B

### Effects of the Invention

According to the winding spool of the present invention, the force in the vertical direction of a bonding wire wound on the spool is dispersed; thus, unwinding defects due to the wire dropping into gaps between the wire wound portion and the flanges can be reduced. In addition, a sufficient amount of wire can be wound, winding on the winding spool of the present invention with the winding structure of the present invention produces a synergistic effect, and excellent unwinding properties are further obtained against a large impact. Moreover, due to storage in the spool case of the present invention, excellent unwinding properties can also be maintained against vibration and impacts during transportation. As a result, a good joining method for electrodes can be maintained.

### Brief Description of Drawings

[Fig. 1] Fig. 1 is a perspective view showing an embodiment of the winding spool for bonding wires of the present invention, and Figs. 1 (a) to (i) show respective embodiments.
[Fig. 2] Fig. 2 is a perspective view showing an embodiment of the body and cover portion of the spool case of the present invention, and Figs. 2 (a) to (e) show respective embodiments.
[Fig. 3] Fig. 3 is a schematic view showing the mounted state of the winding spool attached to a motor rotating shaft of a wire bonding device.
[Fig. 4] Fig. 4 is a schematic diagram showing the winding structure of the bonding wire of the present invention and an elevation angle 19.
[Fig. 5] Figs. 5 (a) to (g) show respective embodiments of the left and right reinforcing ribs of the winding spool of the present invention.
[Fig. 6] Fig. 6 is a schematic diagram showing a bonding wire unwinding test.
[Fig. 7] Fig. 7 is a plan view showing a state of winding collapse of the winding structure of the bonding wire.

### Description of Embodiments

As examples of embodiments of the present invention, the embodiments of the present invention are described below based on the drawings. Figs. 1 and 2 show embodiments of the present invention. The winding spool 10 shown in Fig. 1 is an integrated product obtained by injection molding of a transparent impact-resistant polystyrene resin. The basic structure of the winding spool 10 comprises a drum portion 12, left and right flange portions 13, and a perforated guide portion 14. The perforated guide portion 14 has a guide hole 17 on the center line thereof. The guide hole 17 can be fixed to a motor rotating shaft (not shown) of a wire bonding device. A hollow disc-like support portion 15 from the drum portion 12 to the left and right flange portions 13 internally comprises four left and right reinforcing ribs 16 arranged in a cross shape on each of the front and back surfaces thereof. Fig. 1 shows the left reinforcing ribs 16. Both ends of the respective left reinforcing ribs 16 are integrally connected to the perforated guide portion 14 and the drum portion 12. Moreover, the height of the left reinforcing ribs 16 is the same as the height of the outer peripheral surface of the left flange portion 13. Although it is difficult to read from the drawing, the left and right flange portions 13 each have an elevation angle 19 of 81 degrees, and the width between the outer peripheral surfaces of the left and right flange portions 13 is wider than the width between the inner peripheral surfaces. In addition, the left and right flange portions 13 of the winding spool 10 are each provided with a cut groove 18 for stopping the beginning end and the terminal end of the bonding wire.

The spool case 20 shown in Fig. 2 represents an embodiment of Claim 10. The spool case 20 shown in Fig. 2 comprises a cover portion 21 and a body 31, both of which are made of polyethylene terephthalate (PET). The cover portion 21 and the body 31 are each formed by a vacuum-forming method or the like. In the cover portion 21, a fitting projection 23 having an approximately square pyramid trapezoidal shape is expanded toward the inside of an outer peripheral flange 22. A circular arc groove 24 for receiving the winding spool 10 is formed in the center of the fitting projection 23. Further, side walls of the fitting projection 23 each have two engagement pieces 25 (four pieces in total). The bottom of the circular arc groove 24 has a projecting leg groove 26. The circular arc groove 24 has a shape that is along the outer peripheral edges of the left and right flange portions 13 of the winding spool 10 and is obtained by cutting a circular arc in which the ratio of length to height is approximately 7:2 (length:height ≈ 7:2). The depth of the circular arc groove 24 is approximately the same as the height of the projecting leg groove 26. Although it is not shown, the cover portion defined in Claim 11 has an effect that the cover portion is in line contact with the spool case 20 at positions in which the cover portion abuts on the spool case 20 so that a large impact is absorbed.

The body 31 has a raised peripheral wall 33 having an approximately square pyramid trapezoidal shape that is expanded toward the inside of an upper peripheral flange 32. The two opposing side walls of the raised peripheral wall 33 are each provided with three expanded portions 34. Moreover, the side walls of the body 31 each have two locking pieces 35 (four pieces in total) corresponding to the respective engagement pieces 25 of the cover portion 21. The tip of the three expanded portions 34 on both sides of the raised peripheral wall 33 abuts and fixes the spool case 20.

The left and right flange portions 13 of the winding spool 10 can be supported by abutting of the expanded portions 34 on at least one point of each side surface of the spool case. The spool case 20 of the present invention has a space for the winding spool 10 between the winding spool 10 and the spool case 20 in order to deal with a large impact from the outside. Specifically, it is preferable to provide a space of 1 mm or less, and preferably 0.5 mm or less, in the front-rear and right-left directions between the winding spool 10 and the spool case 20.

The spool case 20 is configured such that the fitting projection 23 of the cover portion 21 fits into the raised peripheral wall 33 of the body 31, and the engagement pieces 25 of the cover portion 21 and the locking pieces 35 of the body 31 fit to each other. The winding spool 10 placed in the spool case 20 is held in such a manner that the bottom surface of the raised peripheral wall 33 of the body 31 is in point contact with the winding spool 10 and the circular arc groove 24 of the cover portion 21 is in line contact with the winding spool 10. The width and length of the cover portion 21 and body 31 of the spool case 20 are greater than the width and length of the winding spool 10, and the expanded portions 34 of the body 31 prevents large horizontal rolling of the winding spool 10. Moreover, the height of the circular arc groove 24 is approximately the same as the height of the projecting leg groove 26. Therefore, the winding spool 10 is swingable in the narrow gap between the winding spool 10 and the raised peripheral wall 33 of the body 31.

After being transported to a customer, the winding spool 10 for bonding wires is attached to a motor rotating shaft 41 of a bonding device 40 for a bonding wire 42, as shown in Fig. 3. The bonding device 40 is generally designed so as to be applicable to winding spools in which the width between the outermost surfaces of left and right flange portions 13 is 31 to 40 mm. General winding spools have a diameter of 88 mm; however, winding spools having a diameter of up to 150 mm can also be attached. After attachment, the winding spool 10 is rotated to supply a predetermined length of the bonding wire 42.

The supplied bonding wire 42 is maintained under air tension, held by a wire clamp 43, supplied from a capillary 44, and then subjected to ultrasonic bonding, spot bonding, ball bonding, or the like to bond the bonding wire to electrode members, electrode connection units, circuit boards, or the like comprising, as a main component, one or more elements selected from aluminum (Al), nickel (Ni), copper (Cu), silicon (Si), silver (Ag), palladium (Pd), platinum (Pt), tin (Sn), iron (Fe), magnesium (Mg), etc.

### Examples

### (Example 1)

A winding spool 10 winding 500 m of Al-0.5 mass% Ni alloy bonding wire (diameter: 400 µm) is explained. The winding spool 10 was produced using a transparent polycarbonate resin. The thickness of the perforated guide portion 14 with an 11-mm guide hole 17 is about 1.5 to 2.5 mm, the diameter of a drum portion 12 is 50 mm, the width thereof is 40 mm, and the diameter of left and right flange portions 13 is 88 mm. The number of reinforcing ribs 16 is 4 on each of the two sides of the drum portion 12 (the elevation angle 19 of each flange portion 13 is 78 degrees). The length of the individual cut grooves 18 is 5 mm, and the depth thereof is 2 mm. Moreover, the ratio of the vertical height (h) of an inclined portion of the inner surface of each flange portion to the vertical height (H) of the entire inner surface of the flange portion 13 is 100%. Here, the wire was wound by a conventional winding method, which did not create the edge of the present invention. This conventional winding method is referred to as "flat winding" below for convenience.

### (Examples 2 to 7)

In Examples 2 to 7, winding was performed under the same conditions as in Example 1, except for using winding spools 10 in which the wire diameter, the winding length, the elevation angle 19, and the ratio of the vertical height (h) of the inclined portion of the inner surface of each flange portion 13 to the vertical height (H) of the entire inner surface of the flange portion were as shown in Table 1.

### (Examples 8 to 10)

In Examples 8 to 10, winding was performed under the same conditions as in Example 1, except for using winding spools 10 in which the diameter of left and right flange portions 13 was 150 mm and the wire diameter, the winding length, the elevation angle 19, and the ratio of the vertical height (h) of the inclined portion of the inner surface of each flange portion 13 to the vertical height (H) of the entire inner surface of the flange portion were as shown in Table 1.

### (Comparative Examples 1 to 4)

In Comparative Examples 1 to 4, winding was performed under the same conditions as in Example 1, except for using winding spools 10 in which the wire diameter, the winding length, the elevation angle 19, and the ratio of the vertical height (h) of the inclined portion of the inner surface of each flange portion 13 to the vertical height (H) of the entire inner surface of the flange portion were as shown in Table 1.

### (Comparative Examples 5 and 6)

In Comparative Examples 5 and 6, winding was performed under the same conditions as in Example 1, except for using winding spools 10 in which the diameter of left and right flange portions 13 was 150 mm and the wire diameter, the winding length, the elevation angle 19, and the ratio of the vertical height (h) of the inclined portion of the inner surface of each flange portion 13 to the vertical height (H) of the entire inner surface of the flange portion were as shown in Table 1.

### (Examples 11 to 17)

In Examples 11 to 17, an Al-0.5 mass% Ni alloy bonding wire was wound, to obtain the winding structure of the present invention, on winding spools 10 having the same conditions as in Example 1, except that the wire diameter, the winding length, the elevation angle 19, and the ratio of the vertical height (h) of the inclined portion of the inner surface of each flange portion 13 to the vertical height (H) of the entire inner surface of the flange portion were as shown in Table 2.

### (Examples 18 to 20)

In Examples 18 to 20, winding was performed under the same conditions as in Examples 11 to 17, except for using winding spools 10 in which the diameter of left and right flange portions 13 was 150 mm and the wire diameter, the winding length, the elevation angle 19, and the ratio of the vertical height (h) of the inclined portion of the inner surface of each flange portion 13 to the vertical height (H) of the entire inner surface of the flange portion were as shown in Table 2.

### (Comparative Examples 7 to 10)

In Comparative Examples 7 to 10, winding was performed under the same conditions as in Example 1, except for using winding spools 10 in which the wire diameter, the winding length, the elevation angle 19, and the ratio of the vertical height (h) of the inclined portion of the inner surface of each flange portion 13 to the vertical height (H) of the entire inner surface of the flange portion were as shown in Table 2.

### (Comparative Examples 11 and 12)

In Comparative Examples 11 and 12, winding was performed under the same conditions as in Example 1, except for using winding spools 10 in which the diameter of left and right flange portions 13 was 150 mm and the wire diameter, the winding length, the elevation angle 19, and the ratio of the vertical height (h) of the inclined portion of the inner surface of each flange portion 13 to the vertical height (H) of the entire inner surface of the flange portion were as shown in Table 2.

### (Examples 21 to 27)

In Examples 21 to 27, winding was performed under the same conditions as in Examples 11 to 17, except for using winding spools 10 in which the wire diameter, the winding length, the elevation angle 19, and the ratio of the vertical height (h) of the inclined portion of the inner surface of each flange portion 13 to the vertical height (H) of the entire inner surface of the flange portion were as shown in Fig. 3. Two of the winding spools 10 were inserted into the respective spool cases of the present invention, and each case was covered with the same cover portion as the cover portion 21 or with a cover portion made of a film.

The body 31 of the case of the present invention has an approximately square pyramid trapezoidal shape with a depth of 84 mm, a bottom surface of 90 mm x 46 mm, and an upper space of 92 mm x 48 mm, and the entire periphery of the upper surface is provided with a 3-mm upper peripheral flange 32. Moreover, both side surfaces of the body 31 facing the left and right flange portions 13 of the winding spool 10 are each provided with three expanded portions 34, each of which has a semi-cylindrical shape with a length of 70 mm. The tip of each of the center expanded portions 34 is in contact with the bottom surface of the body 31, and the width between the center expanded portions 34 is equivalent to the width between the left and right flange portions 13 of the winding spool 10 so that the center expanded portions 34 are in contact with the winding spool 10 by the left and right flange portions 13.

### (Examples 28 to 30)

In Examples 28 to 30, winding was performed under the same conditions as in Examples 11 to 17, except for using winding spools 10 in which the diameter of the left and right flange portions 13 was 150 mm and the wire diameter, the winding length, the elevation angle 19, and the ratio of the vertical height (h) of the inclined portion of the inner surface of each flange portion 13 to the vertical height (H) of the entire inner surface of the flange portion were as shown in Table 3. Two of the winding spools 10 were inserted into the respective spool cases of the present invention, which were the same as the body 31 of Fig. 2. Each case was covered with the same cover portion as the cover portion 21 or with a cover portion made of a film.

### (Comparative Examples 13 to 16)

In Comparative Examples 13 to 16, winding was performed under the same conditions as in Examples 21 to 27, except for using winding spools 10 in which the wire diameter, the winding length, the elevation angle 19, and the ratio of the vertical height (h) of the inclined portion of the inner surface of each flange portion 13 to the vertical height (H) of the entire inner surface of the flange portion were as shown in Table 3. Two of the winding spools 10 were inserted into respective conventional cases, and each case was covered with the same cover portion as the cover portion 21.

### (Comparative Examples 17 and 18)

In Comparative Examples 17 and 18, winding was performed under the same conditions as in Examples 21 to 27, except for using winding spools 10 in which the diameter of left and right flange portions 13 was 150 mm and the wire diameter, the winding length, the elevation angle 19, and the ratio of the vertical height (h) of the inclined portion of the inner surface of each flange portion 13 to the vertical height (H) of the entire inner surface of the flange portion were as shown in Table 3. Two of the winding spools 10 were inserted into respective conventional spool cases, and each case was covered with the same cover portion as the cover portion 21.

As for the conventional case, the winding spools 10 are horizontally placed, and the cover is put on the side surface of the flange portion 13. There is no structural body, such as the expanded portion of the present invention, between the bottom surface of the spool case and the cover portion, and the inner surface of the case and the flange portion 13 are in surface contact with each other. Moreover, the conventional case is not covered with a cover portion made of a seal.

### (Impact test)

Twenty winding structures of the bonding wires wound with flat winding on the winding spools 10 of Examples 1 to 10 and Comparative Examples 1 to 6 were dropped four times from a height of 100 mm without being placed in cases.

A guide pin (not shown) placed at a height of 1,600 mm was inserted into the guide hole 17 of each of the twenty winding structures after the impact test. Then, the bonding wire fixed in the cut grooves 18 of the winding spool 10 was cut, and the bonding wire 42 was unwound from the winding structure. Fig. 6 shows a schematic view. In this case, the presence of defects in the bonding wire 42 supplied from the winding spool 10 was observed in a position away from the flange portions 13.

(Attachment and detachment to bonding device and drop test) Using the twenty winding structures of the winding spools 10 of Examples 11 to 20 and Comparative Examples 7 to 12, attachment and detachment to a motor rotating shaft 41 of Orthodyne 3600 Plus (produced by Orthodyne Electronics), which was a bonding device 40 used for wire bonding of Al bonding wires, were repeated 10 times for each spool. The winding structures of the winding spools 10 after attachment and detachment were dropped four times from a height of 200 mm without being placed in cases. Further, the winding structures of the winding spools 10 after dropping were each unwound in the same manner as in the above impact test, and the presence of defects in the bonding wire 42 supplied from the winding spool 10 was observed in a position away from the flange portions 13.

### (Vibration and drop test)

The winding structures of the bonding wires wound on the winding spools 10 of Examples 21 to 30 were each placed in the case of the present invention (20 winding structures per case), and the winding structures of the bonding wires wound on the winding spools 10 of Comparative Examples 13 to 18 were each placed in a conventional case (20 winding structures per case).

Assuming long-distance land transportation, the winding structures of the winding spools 10 placed in the cases of the present invention and the conventional cases were vibrated by a vibration testing machine while in the above cases in the width direction of the left and right flanges for 24 hours with an acceleration of ±1 G at a frequency of 10 Hz. Thereafter, the winding structures of the winding spools 10 placed in the cases were dropped four times from a height of 500 mm after vibration. Further, the winding structures of the winding spools 10 after dropping were each unwound in the same manner as in the above impact test, and the presence of defects in the bonding wire 42 supplied from the winding spool 10 was observed in a position away from the flange portions 13.

### (Test results)

Tables 1, 2, and 3 show the results of a rotary unwinding test after the above tests. Regarding the "Winding method of the present invention" in Tables 2 and 3, when a winding method that resulted in the winding structure of the present invention was used, this case was regarded as "Concave;" and when a winding method that resulted in flat winding was used, this case was regarded as "Flat." Regarding the "Type of case" in Table 3, when the body 31 of the case of the present invention was used, this case was regarded as "New;" and when the conventional case was used, this case was regarded as "Conventional."

Regarding the "Results of rotary unwinding test" in Tables 1, 2, and 3, when the bonding wire 42 supplied from the right side of the flange portion 13 in Fig. 6 was supplied exceeding "b" in the figure (the range of "b" to "c" or on the left side of "c" in the figure), this case was regarded as "supply failure;" and the range of "a" to "b" in the figure was regarded as "good." In the results of the rotary unwinding test, among the twenty spools after the impact test, only spools without any "supply failure" abnormality described above were regarded as "∘," and spools with at least one abnormality were regarded as "×."

**Table 1**

| | Wire diameter (µm) | Winding length (m) | Flange elevation angle (degrees) | Height ratio of inclined portion of the present invention | Results of rotary unwinding test |
|---|---|---|---|---|---|
| Example 1 | 400 | 500 | 78 | 100% | ○ |
| Example 2 | 300 | 600 | 80 | 100% | ○ |
| Example 3 | 200 | 2000 | 83 | 60% | ○ |
| Example 4 | 350 | 700 | 85 | 100% | ○ |
| Example 5 | 100 | 2000 | 77 | 100% | ○ |
| Example 6 | 75 | 2000 | 81 | 80% | ○ |
| Example 7 | 250 | 1500 | 83 | 100% | ○ |
| Example 8 | 300 | 1000 | 79 | 60% | ○ |
| Example 9 | 800 | 500 | 80 | 100% | ○ |
| Example 10 | 600 | 500 | 84 | 100% | ○ |
| Comparative Example 1 | 400 | 500 | 75 | 100% | × |
| Comparative Example 2 | 100 | 2000 | 79 | 45% | × |
| Comparative Example 3 | 75 | 2000 | 90 | 100% | × |
| Comparative Example 4 | 300 | 1000 | 74 | 100% | × |
| Comparative Example 5 | 300 | 3000 | 87 | 100% | × |
| Comparative Example 6 | 700 | 500 | 82 | 40% | × |

**Table 2**

| | Wire diameter (µm) | Winding length (m) | Flange elevation angle (degrees) | Height ratio of inclined portion of the present invention | Winding method of the present invention | Results of rotary unwinding test |
|---|---|---|---|---|---|---|
| Example 11 | 400 | 500 | 78 | 100% | Concave | ○ |
| Example 12 | 300 | 600 | 80 | 100% | Concave | ○ |
| Example 13 | 200 | 2000 | 83 | 60% | Concave | ○ |
| Example 14 | 350 | 700 | 85 | 100% | Concave | ○ |
| Example 15 | 100 | 2000 | 77 | 100% | Concave | ○ |
| Example 16 | 75 | 2000 | 81 | 80% | Concave | ○ |
| Example 17 | 250 | 1500 | 83 | 100% | Concave | ○ |
| Example 18 | 300 | 1000 | 79 | 60% | Concave | ○ |
| Example 19 | 800 | 500 | 80 | 100% | Concave | ○ |
| Example 20 | 600 | 500 | 84 | 100% | Concave | ○ |
| Comparative Example 7 | 400 | 500 | 78 | 100% | Flat | × |
| Comparative Example 8 | 300 | 600 | 80 | 100% | Flat | × |
| Comparative Example 9 | 200 | 2000 | 83 | 60% | Flat | × |
| Comparative Example 10 | 600 | 200 | 85 | 100% | Flat | × |
| Comparative Example 11 | 300 | 3000 | 77 | 100% | Flat | × |
| Comparative Example 12 | 700 | 500 | 81 | 80% | Flat | × |

**Table 3**

| | Wire diameter (µm) | Winding lengt h (m) | Flange elevati on angle (degree s) | Height ratio of inclined portion of the present inventi on | Winding method of the present inventi on | Type of case | Results of rotary unwindi ng test |
|---|---|---|---|---|---|---|---|
| Example 21 | 400 | 500 | 78 | 100% | Concave | New | ○ (○) |
| Example 22 | 300 | 600 | 80 | 100% | Concave | New | ○ (○) |
| Example 23 | 200 | 2000 | 83 | 60% | Concave | New | ○ (○) |
| Example 24 | 350 | 700 | 85 | 100% | Concave | New | ○ (○) |
| Example 25 | 100 | 2000 | 77 | 100% | Concave | New | ○ (○) |
| Example 26 | 75 | 2000 | 81 | 80% | Concave | New | ○ (○) |
| Example 27 | 250 | 1500 | 83 | 100% | Concave | New | ○ (○) |
| Example 28 | 300 | 1000 | 79 | 60% | Concave | New | ○ (○) |
| Example 29 | 800 | 500 | 80 | 100% | Concave | New | ○ (○) |
| Example 30 | 600 | 500 | 84 | 100% | Concave | New | ○ (○) |
| Comparative Example 13 | 400 | 500 | 78 | 100% | Concave | Conventional | × |
| Comparative Example 14 | 300 | 600 | 80 | 100% | Concave | Conventional | × |
| Comparative Example 15 | 200 | 2000 | 83 | 60% | Concave | Conventional | × |
| Comparative Example 16 | 600 | 200 | 85 | 100% | Concave | Conventional | × |
| Comparative Example 17 | 300 | 3000 | 77 | 100% | Concave | Conventional | × |
| Comparative Example 18 | 700 | 500 | 81 | 80% | Concave | Conventional | × |

| | | | | | | | |
|---|---|---|---|---|---|---|---|
| Note: The symbols in parentheses indicate the test results when the test was performed when covering with a cover portion made of a film. | | | | | | | |

In the present invention, whether there was a significant difference in the wire diameter of bonding wires was additionally evaluated. Five types of bonding wires having a wire diameter of 200 µm to 800 µm were each wound on a spool having a flange diameter of 150 mm, which was the same as those of Examples 8 to 10. In the spools used herein, the flanges had an elevation angle of 82 degrees, and the height ratio of the inclined portion was 100%. The impact test conditions were flat winding, and twenty of the spools were dropped four times from a height of 100 mm without being placed in cases. Table 4 shows the results. All of the five wires showed excellent results in the unwinding test; however, a winding flaw occurred in Example 31, in which the wire diameter was 200 µm, and Example 35, in which the wire diameter was 800 µm. These results revealed that the optimal wire diameter of bonding wires in the present invention was 300 µm to 600 µm.

**Table 4**

| | Wire diameter (µm) | Winding length (m) | Flange elevation angle (degrees) | Height ratio of inclined portion of the present invention | Winding collapse appearance test | Results of rotary unwinding test |
|---|---|---|---|---|---|---|
| Example 31 | 200 | 5000 | 82 | 100% | × | ○ |
| Example 32 | 300 | 3000 | 82 | 100% | ○ | ○ |
| Example 33 | 500 | 1200 | 82 | 100% | ○ | ○ |
| Example 34 | 600 | 800 | 82 | 100% | ○ | ○ |
| Example 35 | 800 | 600 | 82 | 100% | × | ○ |

The results of the unwinding test in Table 1 reveal that unwinding properties were excellent against most of the vibration and impacts, depending on the angle of the flange portions of the spool, and the proportion of their inclined portions. The results of the unwinding test in Table 2 reveal that a synergistic effect was exhibited against impacts caused by attachment and detachment to bonding devices and dropping by adding the wire winding structure of the present invention in addition to the angle of the flange portions of the spool and the proportion of their inclined portions, and that they could withstand a higher impact than the test performed in Table 1. Table 3 shows the results of an unwinding test in which the vibration of wound spools during transportation was simulated, and the spools were dropped from a position even higher than the position in Table 2. It was found that, when the spool was placed in the spool case of the present invention, excellent unwinding properties could be maintained even against a considerably large impact.

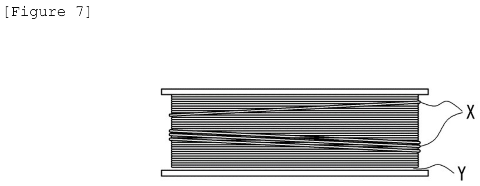

Although it is not shown in Table 1, some of Examples 1 to 10 were not determined as "supply failure" but underwent slight winding collapse. However, the spools having an elevation angle of 79 degrees or more and 83 degrees or less did not undergo such winding collapse. Fig. 7 shows an example of the state of winding collapse of the winding structure of the bonding wire. In Fig. 7, "X" indicates parts where the bonding wire was loosened, and "Y" indicates a part where a gap was formed.

In addition, the winding spools 10 of the above Examples were each mounted in a bonding device 40 for a bonding wire 42 according to the method described in paragraph [0051], and the bonding wire was supplied and subjected to ultrasonic bonding etc. As a result, there were no particular problems.

### Industrial Applicability

The winding spool for bonding wires and the spool case of the present invention particularly relate to aluminum metal and aluminum alloy bonding wires and can be widely used not only for the above bonding wires but also for various bonding wires such as pure silver or silver alloy bonding wires, pure copper, copper alloy, or palladium-coated copper alloy bonding wires, as well as for bonding ribbons.

### [Item 1]

A winding spool for a bonding wire, the winding spool being made of a synthetic resin and comprising a perforated guide portion, a drum portion, and flange portions, wherein:
an inner surface of each flange portion has an inclined portion having an elevation angle of 76 degrees or more and 86 degrees or less, and
the inclined portion has a vertical height (h) that is 50% or more of a vertical height (H) of the entire inner surface of the flange portion.

### [Item 2]

The winding spool according to item 1, wherein the inclined portion has an elevation angle of 79 degrees or more and 83 degrees or less.

### [Item 3]

The winding spool according to item 1 or 2, wherein an outer peripheral surface of the perforated guide portion and an inner peripheral surface of the drum portion are connected by reinforcing ribs on one side or both sides of the winding spool.

### [Item 4]

The winding spool according to item 3, wherein the winding spool has 2 or more and 6 or less reinforcing ribs at least on one side thereof.

### [Item 5]

A method for producing a winding spool for a bonding wire, the winding spool being made of a synthetic resin and comprising a perforated guide portion, a drum portion, and flange portions, wherein:
an inner surface of each flange portion has an inclined portion having an elevation angle of 76 degrees or more and 86 degrees or less, and
the inclined portion has a vertical height (h) that is 50% or more of a vertical height (H) of the entire inner surface of the flange portion.

### [Item 6]

A winding structure of a bonding wire wound on a winding spool made of a synthetic resin and comprising a perforated guide portion, a drum portion, and flange portions, wherein:
an inner surface of each flange portion has an inclined portion having an elevation angle of 76 degrees or more and 86 degrees or less,
the inclined portion has a vertical height (h) that is 50% or more of a vertical height (H) of the entire inner surface of the flange portion, and
the height of an edge of the drum portion on which the bonding wire is wound is higher than the height of the center of the drum portion.

### [Item 7]

The winding structure of a bonding wire according to item 6, wherein the bonding wire is aluminum metal or an aluminum alloy.

### [Item 8]

A method for winding a winding structure of a bonding wire wound on a winding spool made of a synthetic resin and comprising a perforated guide portion, a drum portion, and flange portions, wherein:
an inner surface of each flange portion has an inclined portion having an elevation angle of 76 degrees or more and 86 degrees or less,
the inclined portion has a vertical height (h) that is 50% or more of a vertical height (H) of the entire inner surface of the flange portion, and the height of an edge of the drum portion on which the bonding wire is wound is higher than the height of the center of the drum portion.

### [Item 9]

A bonding method comprising bonding a bonding wire supplied from a winding structure of the bonding wire wound on a winding spool made of a synthetic resin and comprising a perforated guide portion, a drum portion, and flange portions, wherein:
an inner surface of each flange portion has an inclined portion having an elevation angle of 76 degrees or more and 86 degrees or less,
the inclined portion has a vertical height (h) that is 50% or more of a vertical height (H) of the entire inner surface of the flange portion,
in the winding structure of the bonding wire, the height of an edge of the drum portion on which the bonding wire is wound is higher than the height of the center of the drum portion, and
the winding wire is bonded to an electrode member, an electrode connection unit, or a circuit board.

### [Item 10]

A spool case for winding spools, the spool case comprising a cover portion and a body made of a synthetic resin, wherein:
the body has an approximately square pyramid trapezoidal shape with an opening on a side of the cover portion, and
side facing surfaces of the body each have one or more expanded portions.

### [Item 11]

The spool case for winding spools according to item 10, wherein the cover portion does not allow oxygen and moisture to pass through and is a peelable film.

### [Item 12]

The spool case for winding spools according to item 10, wherein:
the cover portion is made of a synthetic resin and has a fitting projection having an approximately square pyramid trapezoidal shape in the inside of an outer peripheral flange,
the fitting projection has a circular arc groove in the center thereof and engagement pieces on the side walls thereof, and
the circular arc groove has a shape along the peripheral edges of left and right flange portions of a winding spool for a bonding wire.

### [Item 13]

A method for producing a spool case for winding spools, the spool case comprising a cover portion and a body made of a synthetic resin, wherein:
the body has an approximately square pyramid trapezoidal shape with an opening on a side of the cover portion, and
side facing surfaces of the body each have one or more expanded portions.

### Explanation of Reference Signs

- 10:: Winding spool
- 12:: Drum portion
- 13:: Flange portion
- 14:: Perforated guide portion
- 15:: Hollow disc-like support portion
- 16:: Reinforcing rib
- 17:: Guide hole
- 18:: Cut groove
- 19:: Elevation angle
- 20:: Spool case
- 21:: Cover portion
- 22:: Outer peripheral flange
- 23:: Fitting projection
- 24:: Circular arc groove
- 25:: Engagement piece
- 26:: Projecting leg groove
- 31:: Body
- 32:: Upper peripheral flange
- 33:: Raised peripheral wall
- 34:: Expanded portion
- 35:: Locking piece
- 40:: Bonding device
- 41:: Motor rotating shaft
- 42:: Bonding wire
- 43:: Wire clamp
- 44:: Capillary

## Claims

1. A bonding method comprising bonding the bonding wire (42) supplied from a winding structure of the bonding wire (42),
**characterized in that**:
the winding structure of the bonding wire (42) wound on a winding spool (10), the winding spool (10) being made of a synthetic resin and comprising a perforated guide portion (14), a drum portion (12), and flange portions (13), wherein:
an inner surface of each flange portion (13) has an inclined portion having an elevation angle of 76 degrees or more and 86 degrees or less, and
the inclined portion has a vertical height (h) that is 50% or more of a vertical height (H) of the entire inner surface of the flange portion (13),
wherein
a first wound height is higher than a second wound height,
wherein the first wound height is a height of the bonding wire (42) wound in an edge space between the flange portion (13) and a line assumed to be drawn from an intersection of the inner surface of the flange portion (13) and the drum portion (12) in a direction perpendicular to the drum portion (12),
wherein the intersection is a starting point at which the flange portion (13) rises, and the second wound height is a height of the outermost layer of the bonding wire (42) wound on the drum portion (12) other than the edge space, and
the bonding wire (42) is bonded to an electrode member, an electrode connection unit, or a circuit board using ultrasonic bonding, spot bonding or ball bonding.

2. The bonding method according to claim 1, wherein the wire diameter of the bonding wire (42) is 75 µm or more and 800 µm or less.

3. The bonding method according to claim 1, wherein the winding length of the bonding wire (42) is 500 m or more and 2000 m or less.

4. The bonding method according to claim 1, wherein a main component of the electrode member, the electrode connection unit, or the circuit board is one or more elements selected from aluminum (Al) , nickel (Ni), copper (Cu), silicon (Si), silver (Ag), palladium (Pd), platinum (Pt), tin (Sn), iron (Fe), and magnesium (Mg).

5. The bonding method according to claim 1, wherein bonding ribbons are used as the bonding wire.

6. The bonding method according to any one of claims 1 to 4, wherein the bonding wire (42) is made of aluminum metal, aluminum alloy, pure silver, silver alloy, pure copper, copper alloy, or palladium-coated copper alloy.

7. An electrode member that is used for the bonding method according to any one of claims 1 to 4.

8. A winding structure of the bonding wire (42) wound on a winding spool (10), the winding spool (10) being made of a synthetic resin and comprising a perforated guide portion (14), a drum portion (12), and flange portions (13),
**characterized in that**:
an inner surface of each flange portion (13) has an inclined portion having an elevation angle of 76 degrees or more and 86 degrees or less, and
the inclined portion has a vertical height (h) that is 50% or more of a vertical height (H) of the entire inner surface of the flange portion (13),
an outer peripheral surface of the perforated guide portion (14) and an inner peripheral surface of the drum portion (12) are connected by reinforcing ribs on one side or both sides of the winding spool,
the wire diameter of the bonding wire (42) is 75 µm or more and 800 µm or less,
wherein
a first wound height is higher than a second wound height, wherein the first wound height is a height of the bonding wire (42) wound in an edge space between the flange portion (13) and a line assumed to be drawn from an intersection of the inner surface of the flange portion (13) and the drum portion (12) in a direction perpendicular to the drum portion (12), wherein the intersection is a starting point at which the flange portion (13) rises, and the second wound height is a height of the outermost layer of the bonding wire (42) wound on the drum portion (12) other than the edge space.

9. A winding structure of the bonding wire (42) wound on a winding spool (10), the winding spool (10) being made of a synthetic resin and comprising a perforated guide portion (14), a drum portion (12), and flange portions (13), **characterized in that**:
an inner surface of each flange portion (13) has an inclined portion having an elevation angle of 76 degrees or more and 86 degrees or less, and
the inclined portion has a vertical height (h) that is 50% or more of a vertical height (H) of the entire inner surface of the flange portion (13),
an outer peripheral surface of the perforated guide portion (14) and an inner peripheral surface of the drum portion (12) are connected by reinforcing ribs on one side or both sides of the winding spool,
the bonding wire (42) is made of aluminum metal, aluminum alloy, pure silver, silver alloy, pure copper, copper alloy, or palladium-coated copper alloy,
wherein
a first wound height is higher than a second wound height, wherein the first wound height is a height of the bonding wire (42) wound in an edge space between the flange portion (13) and a line assumed to be drawn from an intersection of the inner surface of the flange portion (13) and the drum portion (12) in a direction perpendicular to the drum portion (12), wherein the intersection is a starting point at which the flange portion (13) rises, and the second wound height is a height of the outermost layer of the bonding wire (42) wound on the drum portion (12) other than the edge space.

10. The winding structure of the bonding wire (42) according to claim 8 or 9, wherein the inclined portion has an elevation angle of 79 degrees or more and 83 degrees or less.

11. The winding structure of the bonding wire (42) according to claim 8 or 9, wherein the winding spool has 2 or more and 6 or less reinforcing ribs at least on one side thereof.

12. The winding structure of the bonding wire (42) according to claim 8 or 9, wherein a width between an outermost surfaces of left and right flange portions (13) is 31 mm to 40 mm, and a diameter of the winding spool (10) is up to 150 mm.

13. The winding structure of the bonding wire (42) according to claim 8 or 9, wherein the winding length of the bonding wire (42) is 500 m or more and 2000 m or less.

14. The winding structure of the bonding wire (42) according to claim 8 or 9, wherein bonding ribbons are used as the bonding wire (42).

15. A winding spool for use for the winding structure of the bonding wire (42) according to claim 8 or 9.

16. A winding spool being made of a synthetic resin and comprising a cylindrical drum portion (12), left and right flange portions (13, 13), and a perforated guide portion (14) wherein:
the flange portions (13, 13) are connected on both ends of the drum portion (12),
an inner surface of each flange portion (13, 13) has an inclined portion having an elevation angle of 73 degrees or more and 86 degrees or less, and
the inclined portion has a vertical height (h) that is 50% or more of a vertical height (H) of the entire inner surface of the flange portion,
an outer peripheral surface of the perforated guide portion and an inner peripheral surface of the drum portion are connected by reinforcing ribs on one side or both sides of the winding spool,
the winding spool has 2 or more and 6 or less reinforcing ribs at least on one side thereof,
the winding spool has two or more and six or less reinforcing ribs (16), and both ends of the respective reinforcing ribs (16) are integrally connected to the perforated guide portion (14) and the drum portion (12).
